# EUROPEAN PATENT APPLICATION

(11) **EP 4 718 973 A1**
(43) Date of publication of application: **01.04.2026**
(21) Application number: 25185155.6
(22) Date of filing: 25.06.2025
(51) Int. Cl.: H10B 63/00, G11C 13/00, H10N 70/20, H10N 70/00

(54) **MEMORY DEVICE AND DRIVING METHOD THEREOF**

(30) Priority: 25.09.2024 KR 20240130273
(71) Applicant: Samsung Electronics Co., Ltd., Suwon-si, Gyeonggi-do 16677 (KR); Ulsan National Institute of Science and Technology (UNIST), Eonyang-eup Ulju-gun Ulsan 44919 (KR)
(72) Inventor: PARK, Garam, 16677 Suwon-si (KR); YOON, Tae-Sik, 44919 Ulju-gun (KR); HAN, Jimin, 44919 Ulju-gun (KR); KIM, Yumin, 16677 Suwon-si (KR); LEE, Minhyun, 16677 Suwon-si (KR); HYUN, Seung Dam, 16677 Suwon-si (KR); NOH, Taeyun, 44919 Ulju-gun (KR); JEONG, Boyoung, 44919 Ulju-gun (KR)
(74) Representative: Elkington and Fife LLP

(57) **Abstract**

A memory device (100) includes a substrate (101), a channel layer (160) on one surface of the substrate and including a semiconductor oxide, a gate electrode (120) on the channel layer (160), a reservoir layer (140) between the channel layer (160) and the gate electrode (120), an electrolyte layer (150) between the channel layer (160) and the reservoir layer (140), and a gate oxide layer (130) between the gate electrode (120) and the reservoir layer (140), wherein the reservoir layer (140) is capable of transferring oxygen vacancies therein to the channel layer (160) or receiving oxygen vacancies transferred from the channel layer (160) depending on a voltage applied to the gate electrode (120), and a thickness of the electrolyte layer (150) is less than 5 nm.

## Description

### FIELD OF THE INVENTION

The present disclosure relates to memory devices and driving methods thereof.

### BACKGROUND OF THE INVENTION

Manufacturing technology for NAND flash memory devices is advancing toward improving the integration density, operating speed, and/or yield of semiconductor memory devices. In order to increase the integration of semiconductor memory devices, vertical NAND (VNAND) flash memory devices have been suggested.

NAND flash memory devices, including vertical NAND flash memory devices, implement memory functions through the charge trap flash (CTF) method, which applies a voltage to a gate electrode to move electrons present in a channel layer to a trap layer through the tunneling effect. However, the CTF method needs a relatively high voltage to be applied to the gate electrode, which causes interference problems between unit cells, and thus has limitations in reducing the thickness of the gate electrode and/or trap layer.

Meanwhile, an electrochemical random-access memory (ECRAM) device is known that implements a memory function by applying a voltage to the gate electrode and moving ions present in the channel layer to change the electrical conductivity and/or the threshold voltage of the channel layer.

### SUMMARY OF THE INVENTION

Some example embodiments of the present disclosure provide memory devices capable of implementing a memory function even when a relatively small voltage is applied to the gate electrode and/or improving integration density, by borrowing the operating principle of an electrochemical random-access memory device to improve the charge trap flash (CTF) method that tends to cause technical problems due to interference problems between unit cells, and/or driving methods of the memory device.

The effects of present disclosure are not limited to those mentioned above, and other effects not mentioned will be clearly understood by those skilled in the art from the following description.

According to an example embodiment of the present disclosure, a memory device may include a substrate, a channel layer on one surface of the substrate and including a semiconductor oxide, a gate electrode between the substrate and the channel layer, a reservoir layer between the channel layer and the gate electrode, an electrolyte layer between the channel layer and the reservoir layer, and a gate oxide layer between the gate electrode and the reservoir layer, wherein the reservoir layer is capable of transferring oxygen vacancies therein to the channel layer or receiving oxygen vacancies transferred from the channel layer, depending on a voltage applied to the gate electrode, and a thickness of the electrolyte layer is less than 5 nm.

Proposed embodiments may provide an electrochemical memory device capable of implementing a memory function even when a relatively small voltage is applied to the gate electrode and improving integration density of unit cells by borrowing the operating principle of an electrochemical random-access memory (ECRAM) device. In particular, as a result of the proposed concept(s), it may be possible to reduce a threshold voltage of the electrochemical memory device when it is driven, thus facilitating a memory function even when a relatively small voltage is applied to the gate electrode. Embodiments may also provide a method of driving the electrochemical memory device.

According to an example embodiment of the present disclosure, there is provided a method of driving a memory device including a substrate, a channel layer on one surface of the substrate and including a semiconductor oxide, a gate electrode between the substrate and the channel layer, a reservoir layer between the channel layer and the gate electrode, an electrolyte layer between the channel layer and the reservoir layer and having a thickness of less than 5 nm, and a gate oxide layer between the gate electrode and the reservoir layer. The method may include transferring oxygen vacancies present in the reservoir layer to the channel layer or transferring oxygen vacancies present in the channel layer to the gate electrode when a voltage is applied to the gate electrode such that an electrical conductivity and a threshold voltage (Vₜₕ) of the channel layer change values different from the electrical conductivity and the threshold voltage (Vₜₕ) of the channel layer prior to the application of the voltage to the gate electrode, and performing a write operation or an erase operation as the electrical conductivity and the threshold voltage of the channel layer changes.

Details of other example embodiments are included in the Detailed Description and drawings.

### BRIEF DESCRIPTION OF THE DRAWINGS

The drawings shown in the present disclosure are according to some example embodiments, and ratios of the width, height or thickness of each component is for describing the present disclosure in detail, and the ratio may be different from the actual ones. In addition, each component illustrated in the drawings may be exaggerated to describe the present disclosure in detail. In addition, in a coordinate system shown in the drawing, each axis may can be perpendicular to the others, a direction pointed by an arrow may be a + direction, and a direction opposite to the direction pointed by the arrow (a direction rotated by 180 degrees) may be a - direction, in which:
FIG. 1 schematically illustrates at least a portion of a memory device according to an example embodiment of the present disclosure;
FIG. 2 illustrates a cross-section taken along line AA' of FIG. 1;
FIG. 3 illustrates a cross-section taken along line BB' of FIG. 1;
FIG. 4 is an enlarged view of part P in FIG. 1;
FIG. 5 schematically illustrates at least a portion of a memory device according to an example embodiment of the present disclosure;
FIG. 6 illustrates a cross-section taken along CC' of FIG. 5;
FIG. 7 is an enlarged view of part Q in FIG. 5;
FIG. 8 schematically illustrates at least a portion of the memory device according to an example embodiment of the present disclosure;
FIG. 9 schematically illustrates at least a portion of a memory device according to an example embodiment of the present disclosure;
FIGS. 10 to 13 schematically illustrates at least a portion of a memory device to describe a method of driving the memory device according to an example embodiment of the present disclosure;
FIG. 14 is a perspective view schematically illustrating at least a portion of a memory device according to an example embodiment of the present disclosure;
FIG. 15 is a cross-sectional view taken along line D-D' of FIG. 14;
FIGS. 16 and 17 are graphs showing characteristics of a drain-source current (I_{DS}) with respect to a gate-source voltage (V_{GS}) of a memory device according to some examples of the present disclosure;
FIGS. 18 and 19 are graphs showing characteristics of a drain-source current (I_{DS}) with respect to a gate-source voltage (V_{GS}) of the memory device according to some examples of the present disclosure;
FIG. 20 is a graph showing characteristics of current with respect to the number of times a voltage is applied in pulse form when a voltage is applied to a gate electrode in pulse form in the memory device according to examples of the present disclosure;
FIG. 21 is a graph showing characteristics of a drain-source current (I_{DS}) with respect to a gate-source voltage (V_{GS}) in a memory device according to Comparative Example 1; and
FIG. 22 is a graph showing characteristics of a drain-source current (I_{DS}) with respect to a gate-source voltage (V_{GS}) in a memory device according to Comparative Example 2.

### DETAILED DESCRIPTION OF EMBODIMENTS

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "one of," "any one of," "at least one of," and "one or more of" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

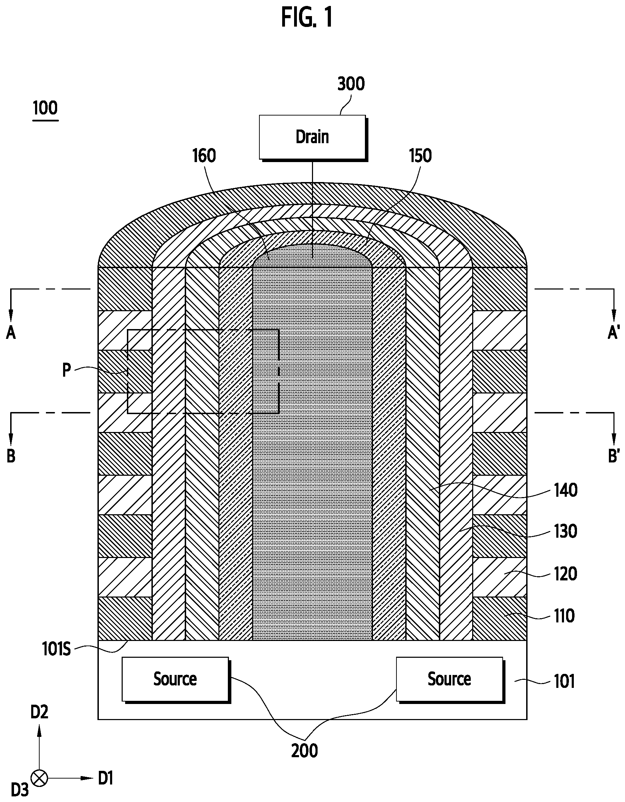

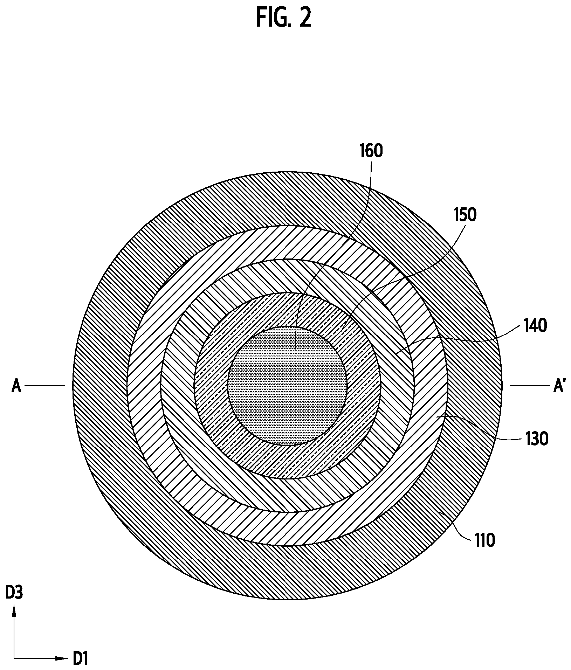

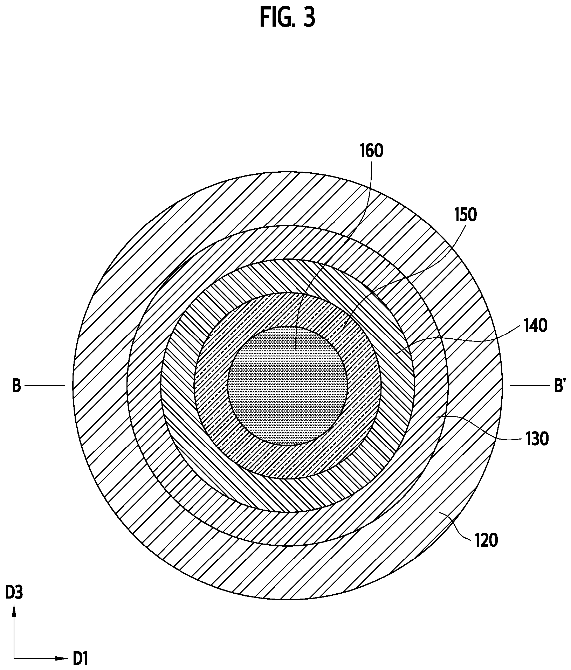

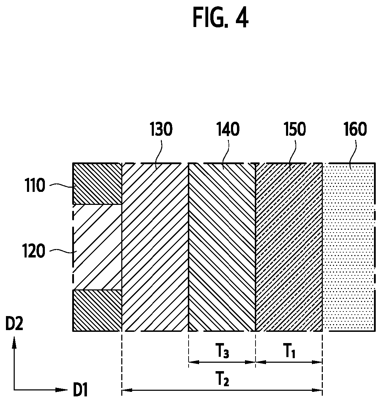

FIG. 1 schematically illustrates at least a portion of a memory device 100 according to an example embodiment of the present disclosure. FIG. 2 illustrates a cross-section taken along line AA' of FIG. 1. FIG. 3 illustrates a cross-section taken along line BB' of FIG. 1. FIG. 4 is an enlarged view of part P in FIG. 1.

The memory device 100 according to an example embodiment of the present disclosure may be, for example, a non-volatile memory device. In one example, the non-volatile memory device may be a flash memory, a read only memory (ROM), a hard disk, a diskette drive, a magnetic tape, or an optical disc, but is not limited thereto. In one example, the non-volatile memory device may be a flash memory. In one example, the flash memory may be a NAND flash memory, and specifically may be a vertical NAND flash memory. In one example, the memory device 100 may be a vertical NAND flash memory device.

The memory device 100 according to an example embodiment of the present disclosure may include a substrate 101, a gate electrode 120, a gate oxide layer 130, a reservoir layer 140, an electrolyte layer 150, and a channel layer 160.

The substrate 101 according to an example embodiment of the present disclosure is not particularly limited, but may be a silicon semiconductor substrate, a plastic substrate, a glass substrate, a compound semiconductor substrate, a ceramic substrate, or a silicon-on-insulator (SOI) substrate. In one example, the substrate 101 may include, although not separately illustrated, an impurity region due to doping, a peripheral circuit for selecting and/or controlling an electronic element such as a transistor or a memory cell, or the like. In one example, the gate electrode 120, the gate oxide layer 130, the reservoir layer 140, the electrolyte layer 150, and the channel layer 160 may be disposed on a surface 101S of the substrate.

In the present specification, a first direction D1 may be a direction parallel to the surface 101S of the substrate, as illustrated in FIG. 1. A second direction D2 may refer to a direction intersecting the first direction D1, and specifically, the second direction D2 may be a direction perpendicular to the surface 101S of the substrate while intersecting the first direction D1. A third direction D3 may be a direction intersecting the first direction D1 as illustrated in FIG. 1, but is parallel to the surface 101S of the substrate.

The gate electrode 120 according to an example embodiment of the present disclosure may be electrically connected to a word line. In one example, the gate electrode 120 may include a metal material having relatively good electrical conductivity, metal nitride, or silicon doped with impurities. In one example, as the metal material having relatively good electrical conductivity, the gate electrode 120 may include one or more selected from the group consisting of gold (Au), silver (Ag), aluminum (Al), titanium (Ti), indium (In), cadmium (Cd), copper (Cu), zinc (Zn), tantalum (Ta), and/or tungsten (W), but is not limited thereto.

The gate electrode 120 according to an example embodiment of the present disclosure may be disposed between the substrate 101 and the channel layer 160. In one example, the gate electrode 120 may be disposed on the channel layer 160. In one example, the gate electrode 120 may be disposed on the substrate 101. In one example, the gate electrode 120 may surround at least a portion of the channel layer 160. In one example, there may be a plurality of gate electrodes 120, and adjacent gate electrodes 120 may be spaced apart from each other based on the second direction D2.

The memory device 100 according to an example embodiment of the present disclosure may include an insulating layer 110. In one example, the insulating layer 110 may surround at least a portion of the channel layer 160. In one example, the insulating layer 110 may include an insulating material. For example, the insulating material is not particularly limited as long as it has electrical insulation properties, but may include one or more selected from the group consisting of silicon oxide, silicon nitride, and/or silicon oxynitride.

There may be a plurality of insulating layers 110 according to the example embodiment of the present disclosure, and adjacent insulating layers 110 may be spaced apart from each other based on the second direction D2. In one example, the insulating layer 110 may be disposed so that a space between adjacent gate electrodes 120 is filled with the insulating layer. In one example, the insulating layer 110 may overlap the gate electrode 120 at least in a partial region when viewed in the second direction D2.

Referring to FIG. 1 in one example, the insulating layer 110 and the gate electrode 120 may be alternately stacked on each other, and the insulating layer 110 and the gate electrode 120 may be in contact with each other based on the second direction D2. Referring to FIG. 2, the insulating layer 110 may surround at least a portion of the channel layer 160. Referring to FIG. 3, the gate electrode 120 may surround at least a portion of the channel layer 160.

The channel layer 160 according to an example embodiment of the present disclosure may be disposed on one surface 101S of the substrate. In one example, the channel layer 160 may extend along the second direction D2.

The channel layer 160 according to an example embodiment of the present disclosure may include a semiconductor oxide. In one example, the channel layer 160 may be a semiconductor oxide and include an oxide including one or more selected from the group consisting of tantalum (Ta), hafnium (Hf), aluminum (Al), zinc (Zn), tungsten (W), vanadium (V), titanium (Ti), niobium (Nb), silicon (Si), germanium (Ge), arsenic (As), tellurium (Te), antimony (Sb), gallium (Ga), indium (In), zirconium (Zr), tin (Sn), and/or nickel (Ni). In one example, the channel layer 160 may include indium gallium zinc oxide (IGZO). However, without being limited thereto, the channel layer 160 may include one or more selected from the group consisting of indium tungsten oxide (IWO), indium tin gallium oxide (ITGO), indium aluminum zinc oxide (IAZO), indium gallium oxide (IGO), indium tin zinc oxide (ITZO), zinc tin oxide (ZTO), indium zinc oxide (IZO), zinc oxide (ZnO), tungsten oxide (WO), indium gallium silicon oxide (IGSO), indium oxide (InO), tin oxide (SnO), titanium oxide (TiO), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SiInZnO), zinc tin oxide (ZnSnO), aluminum zinc tin oxide (AlZnSnO), gallium zinc tin oxide (GaZnSnO), zirconium zinc tin oxide (ZrZnSnO), and/or indium gallium silicon oxide (InGaSiO). In one example, the channel layer 160 may include oxygen vacancies.

The reservoir layer 140 according to an example embodiment of the present disclosure may be disposed between the channel layer 160 and the gate electrode 120. In one example, the reservoir layer 140 may include oxygen vacancies. In one example, the reservoir layer 140 may receive oxygen vacancies from the channel layer 160 or transfer oxygen vacancies to the channel layer 160 depending on the voltage applied to the gate electrode 120. In other words, the reservoir layer may be capable of transferring oxygen vacancies therein to the channel layer or receiving oxygen vacancies transferred from the channel layer, depending on a voltage applied to the gate electrode. That is, the reservoir layer 140 may include oxygen vacancies to be transferred to the channel layer 160 or oxygen vacancies transferred from the channel layer 160 depending on the voltage applied to the gate electrode 120. In the present specification, the movement of oxygen vacancies is performed in the opposite direction to the movement of oxygen ions, and the ions present in the channel layer 160 may be, for example, oxygen ions. In one example, the reservoir layer 140 may exchange oxygen vacancies with the channel layer 160, and change the electrical conductivity and/or the threshold voltage of the channel layer 160 depending on the degree of exchange of oxygen vacancies.

The reservoir layer 140 according to the example embodiment of the present disclosure may include an oxide having a metal element-oxygen bond. In one example, the oxide having the metal element-oxygen bond included in the reservoir layer 140 may be an oxide including one or more selected from a group of metal elements consisting of hafnium (Hf), cerium (Ce), tantalum (Ta), gallium (Ga), nickel (Ni), aluminum (Al), zinc (Zn), tungsten (W), vanadium (V), titanium (Ti), niobium (Nb), germanium (Ge), arsenic (As), tellurium (Te), antimony (Sb), indium (In), zirconium (Zr), and/or tin (Sn), but is not limited thereto. In one example, the oxide having the metal element-oxygen bond included in the reservoir layer 140 may include one or more of a single metal oxide in which one metal element selected from the aforementioned group of metal elements is bonded to oxygen or a composite metal oxide in which two or more metal elements selected from the aforementioned group of metal elements are bonded to oxygen. In one example, the oxide having the metal element-oxygen bond included in the reservoir layer 140 may include one or more selected from the group consisting of hafnium oxide, cerium oxide, tantalum oxide, gallium oxide, and/or nickel oxide.

The reservoir layer 140 according to the example embodiment of the present disclosure may transfer oxygen vacancies to the channel layer 160 when a positive voltage is applied to the gate electrode 120. In one example, when a negative voltage is applied to the gate electrode 120, oxygen vacancies may be transferred from the channel layer 160. In the process, the reservoir layer 140 may exchange oxygen vacancies with the channel layer 160, and change the electrical conductivity and/or the threshold voltage of the channel layer 160 depending on the degree of exchange of oxygen vacancies. The details will be described below.

The electrolyte layer 150 according to the example embodiment of the present disclosure may be disposed between the channel layer 160 and the reservoir layer 140. In one example, the electrolyte layer 150 may smoothly pass oxygen vacancies such that oxygen vacancies are transferred from the channel layer 160 to the reservoir layer 140 or oxygen vacancies are transferred from the reservoir layer 140 to the channel layer 160 depending on the voltage applied to the gate electrode 120. That is, the electrolyte layer 150 may allow oxygen vacancies transferred from the reservoir layer 140 to the channel layer 160 or transferred from the channel layer 160 to the reservoir layer 140 to pass depending on the voltage applied to the gate electrode 120. In one example, the electrolyte layer 150 may allow the channel layer 160 and the reservoir layer 140 to smoothly exchange oxygen vacancies with each other, and may change the electrical conductivity and/or the threshold voltage of the channel layer 160 depending on the degree of exchange of oxygen vacancies.

The concentration of oxygen vacancies in the reservoir layer 140 according to the example embodiment of the present disclosure may be higher than the concentration of oxygen vacancies in the electrolyte layer 150. Thereby, the oxygen vacancies of the reservoir layer 140 may be smoothly transferred through the electrolyte layer 150 to the channel layer 160. The concentration of oxygen vacancies may be calculated as, for example, the ratio of the number of oxygen (O) actually bonded to metal included in the reservoir layer 140 to the number of bondable sites of oxygen (O) calculated by multiplying the valence of the metal by the number of the corresponding metal, but is not limited thereto.

A thickness T₁ of the electrolyte layer 150 according to an example embodiment of the present disclosure may be less than about 5 nm, about 4.9 nanometers (nm) or less, about 4.8 nm or less, about 4.7 nm or less, about 4.6 nm or less, about 4.5 nm or less, about 4.4 nm or less, about 4.3 nm or less, about 4.2 nm or less, about 4.1 nm or less, or 4 nm or less. In one example, the thickness T₁ of the electrolyte layer 150 may refer to the length of the electrolyte layer 150 along the first direction D1 with reference to FIG. 4. In one example, the thickness T₁ of the electrolyte layer 150 may be greater than or equal to the minimum thickness that may be deposited by, for example, atomic layer deposition (ALD). In one example, the thickness T₁ of the electrolyte layer 150 may be about 0.1 nm or more. In one example, when the thickness T₁ of the electrolyte layer 150 satisfies the above-described range, oxygen vacancies may be smoothly exchanged between the channel layer 160 and the reservoir layer 140, and the electrical conductivity and the threshold voltage of the channel layer 160 may change depending on the degree of exchange of oxygen vacancies, thereby implementing a memory function.

Meanwhile, in one example, remaining layers excluding the electrolyte layer 150 among layers constituting the memory device 100 may be formed by a chemical vapor deposition (CVD) method or a physical vapor deposition (PVD) method in addition to an atomic layer deposition (ALD) method.

A sum T₂ of thicknesses of the reservoir layer 140, the electrolyte layer 150, and the gate oxide layer 130 according to an example embodiment of the present disclosure may be about 30 nm or less, about 29 nm or less, about 28 nm or less, about 27 nm or less, about 26 nm or less, or about 25 nm or less, but is not limited thereto. In one example, when the sum T₂ of the thicknesses of the reservoir layer 140, the electrolyte layer 150, and the gate oxide layer 130 satisfies the above-described range, the memory function may be implemented, and furthermore, the integration density may be improved. In one example, a thickness T₃ of the reservoir layer 140, the thickness T₁ of the electrolyte layer 150, and the thickness of the gate oxide layer 130 may refer to the lengths of respective components along the first direction D1 with reference to FIG. 4.

According to an example embodiment of the present disclosure, the ratio T₁/T₂ of the thickness T₁ of the electrolyte layer 150 to the sum T₂ of the thicknesses of the reservoir layer 140, the electrolyte layer 150, and the gate oxide layer 130 may be about 0.3 or less, about 0.29 or less, about 0.28 or less, about 0.27 or less, about 0.26 or less, or about 0.25 or less, but is not limited thereto. In one example, when the ratio T₁/T₂ satisfies the above-described range, the memory function of the memory device 100 may be implemented, and furthermore, the integration density may be improved.

The thickness T₁ of the electrolyte layer 150 according to an example embodiment of the present disclosure may be thinner than the thickness T₃ of the reservoir layer 140. Thereby, oxygen vacancies may easily move from the electrolyte layer 150 to the reservoir layer 140 and the channel layer 160. In other words, oxygen vacancies may move from with relative ease between the reservoir layer 140 and the channel layer 160 via the electrolyte layer 150.

A ratio T₁/T₃ of the thickness T₁ of the electrolyte layer 150 to the thickness T₃ of the reservoir layer 140 according to an example embodiment of the present disclosure may be about 0.5 or less, about 0.45 or less, about 0.4 or less, about 0.35 or less, about 0.3 or less, about 0.25 or less, about 0.2 or less, about 0.15 or less, or about 0.1 or less, but is not limited thereto. In one example, when the ratio T₁/T₃ satisfies the above-described range, the memory function of the memory device 100 may be implemented, and furthermore, the integration density may be improved.

The electrolyte layer 150 according to the example embodiment of the present disclosure may include an oxide having a metal element-oxygen bond. In one example, the oxide having the metal element-oxygen bond included in the electrolyte layer 150 may be an oxide including one or more selected from a group of metal elements consisting of hafnium (Hf), cerium (Ce), tantalum (Ta), gallium (Ga), nickel (Ni), aluminum (Al), zinc (Zn), tungsten (W), vanadium (V), titanium (Ti), niobium (Nb), germanium (Ge), arsenic (As), tellurium (Te), antimony (Sb), indium (In), zirconium (Zr), and/or tin (Sn), but is not limited thereto. In one example, the oxide having the metal element-oxygen bond included in the electrolyte layer 150 may include one or more of a single metal oxide in which one metal element selected from the aforementioned group of metal elements is bonded to oxygen or a composite metal oxide in which two or more metal elements selected from the aforementioned group of metal elements are bonded to oxygen. In one example, the oxide having the metal element-oxygen bond included in the electrolyte layer 150 may include one or more selected from the group consisting of hafnium oxide, cerium oxide, tantalum oxide, gallium oxide, nickel oxide, and/or aluminum oxide.

The oxygen concentration of the electrolyte layer 150 according to the example embodiment of the present disclosure may be higher than the oxygen concentration of the reservoir layer 140. Thereby, when oxygen vacancies are exchanged between the reservoir layer 140 and the channel layer 160, oxygen vacancies may be reduced or prevented from being captured in the electrolyte layer 150, thereby implementing the memory function.

The gate oxide layer 130 according to an example embodiment of the present disclosure may be disposed between the gate electrode 120 and the reservoir layer 140. In one example, the gate oxide layer 130 may include an oxide having a metal element-oxygen bond. In one example, the oxide having the metal element-oxygen bond included in the gate oxide layer 130 may be an oxide including one or more selected from a group of metal elements consisting of tantalum (Ta), hafnium (Hf), aluminum (Al), zinc (Zn), tungsten (W), vanadium (V), titanium (Ti), niobium (Nb), germanium (Ge), arsenic (As), tellurium (Te), antimony (Sb), gallium (Ga), indium (In), zirconium (Zr), tin (Sn), and/or nickel (Ni), but is not limited thereto. In one example, the oxide having the metal element-oxygen bond included in the gate oxide layer 130 may include one or more of a single metal oxide in which one metal element selected from the aforementioned group of metal elements is bonded to oxygen or a composite metal oxide in which two or more metal elements selected from the aforementioned group of metal elements are bonded to oxygen.

The memory device 100 according to an example embodiment of the present disclosure may include a source electrode 200 and a drain electrode 300. In one example, the channel layer 160 may be electrically connected to the source electrode 200 and the drain electrode 300.

In one example, referring to FIG. 1, the source electrode 200 and the drain electrode 300 may be spaced apart from each other based on the second direction D2. In one example, the source electrode 200 and the drain electrode 300 may each independently include a conductive material. In one example, the conductive material may include one or more selected from the group consisting of doped polysilicon, metal, conductive metal nitride, conductive metal silicide, and/or conductive metal oxide. In one example, the metal may include one or more selected from the group consisting of aluminum (Al), copper (Cu), titanium (Ti), tantalum (Ta), rubidium (Ru), tungsten (W), molybdenum (Mo), platinum (Pt), nickel (Ni), and/or cobalt (Co). In one example, the conductive metal nitride may include one or more selected from TiAl or TiAlN. In one example, the conductive metal silicide may include one or more selected from the group consisting of TiSi, TiSiN, TaSi, TaSiN, RuTiN, NiSi, and/or CoSi. In one example, the conductive metal oxide may include one or more selected from IrOx and/or RuOx.

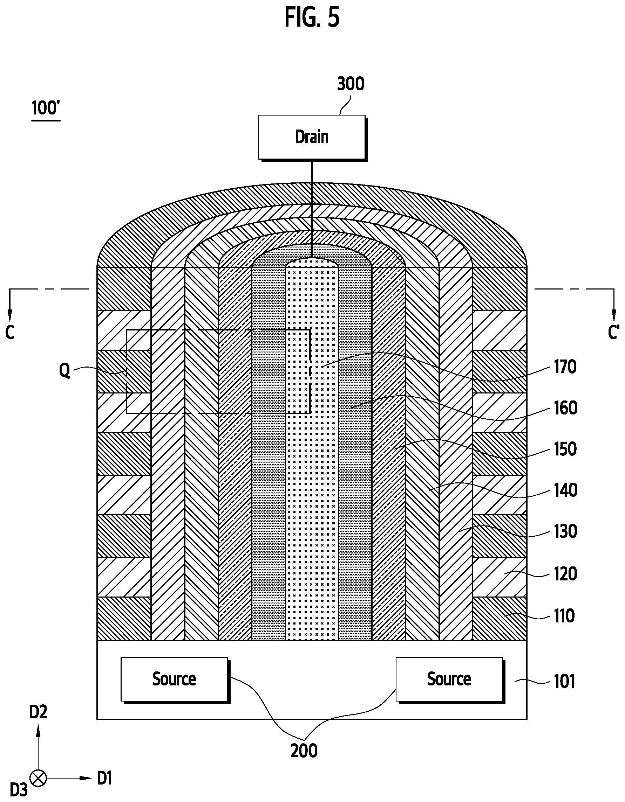

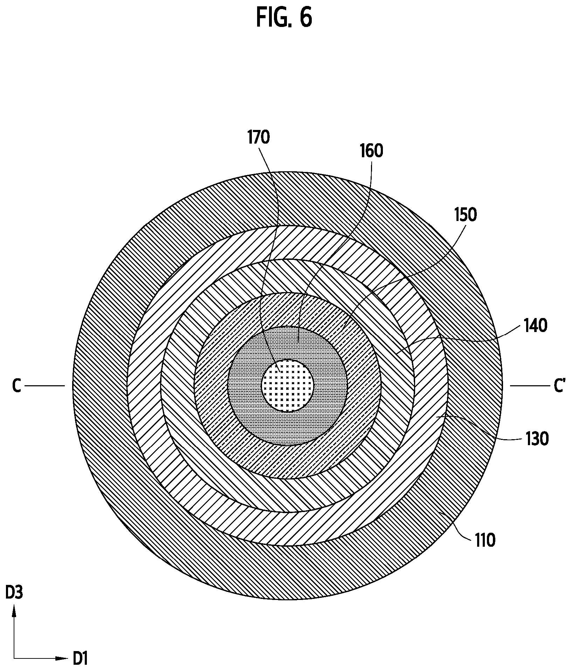

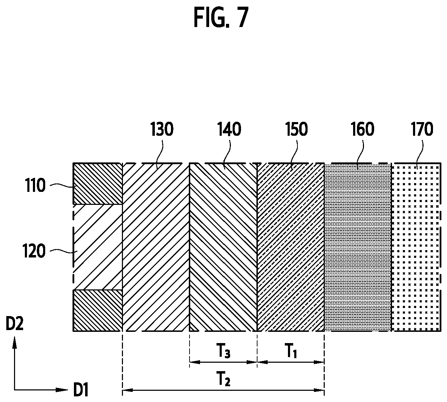

FIG. 5 is a schematic illustration of at least a portion of a memory device 100' according to an example embodiment of the present disclosure. FIG. 6 illustrates a cross-section taken along CC' of FIG. 5. FIG. 7 is an enlarged view of part Q in FIG. 5. The contents of FIGS. 5 to 7 may refer to the description of FIGS. 1 to 4, unless they are contradictory.

The memory device 100' according to an example embodiment of the present disclosure may include a filling layer 170 surrounded by a channel layer 160. In one example, the filling layer 170 may include an insulating material, and the insulating material included in the filling layer 170 may include one or more selected from the group consisting of, for example, air, silicon oxide, silicon nitride, and/or silicon oxynitride.

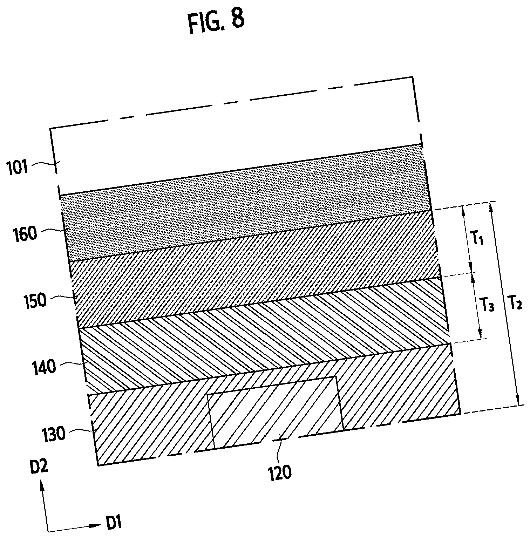

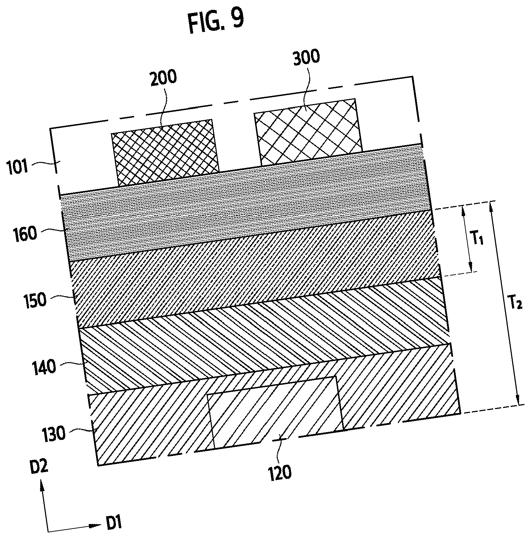

FIGS. 8 and 9 schematically illustrate at least a portion of memory devices according to some example embodiments of the present disclosure. Unlike the memory devices 100 illustrated in FIGS. 1 to 7, the memory devices 100 illustrated in FIGS. 8 and 9 may have the channel layer 160 and the substrate 101 disposed parallel to each other. Below, the contents of FIGS. 8 and 9 may refer to the descriptions of FIGS. 1 to 7, unless they are contradictory.

The gate electrode 120 according to the above example embodiment of the present disclosure illustrated in FIGS. 1 to 7 may be disposed between the substrate 101 and the channel layer 160 as described above. Referring to FIGS. 8 and 9, in some example embodiments, the gate electrode 120 may be disposed parallel to at least a portion of the channel layer 160, the channel layer 160 may be disposed parallel to the substrate 101, and/or the channel layer 160 may be disposed parallel to the substrate 101 along the first direction D1.

The memory device 100 according to an example embodiment of the present disclosure may include the source electrode 200 and the drain electrode 300. In one example, the source electrode 200 and the drain electrode 300 may be spaced apart from each other based on the first direction D1. For example, the source electrode 200 and the drain electrode 300 may be disposed on the channel layer 160 and/or within the substrate 101. Referring to FIGS. 8 and 9, the thickness T₁ of the electrolyte layer 150 described in FIGS. 1 to 7 may refer to the length along the second direction D2 of the electrolyte layer 150, and the thickness T₃ of the reservoir layer 140 and the thickness of the gate oxide layer 130 may refer to the lengths of the respective components along the second direction D2.

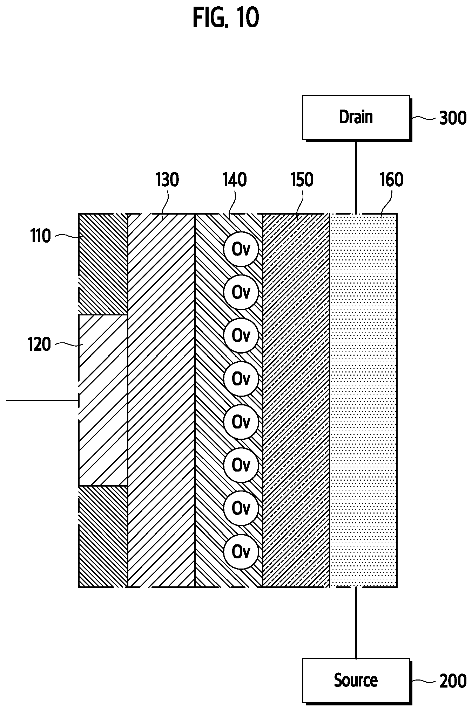

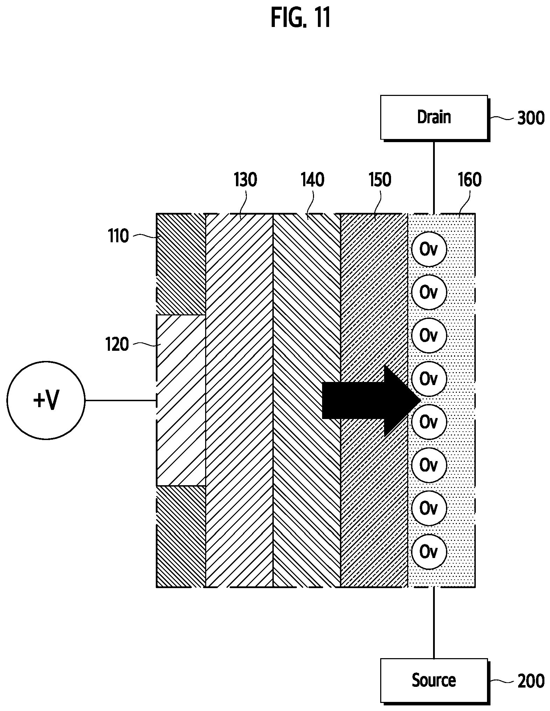

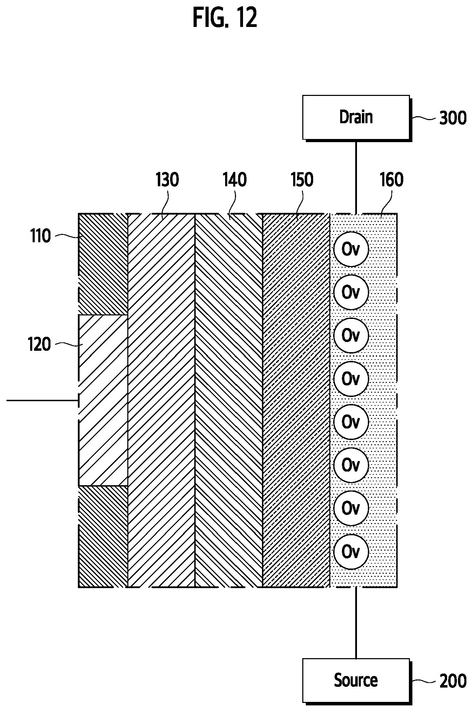

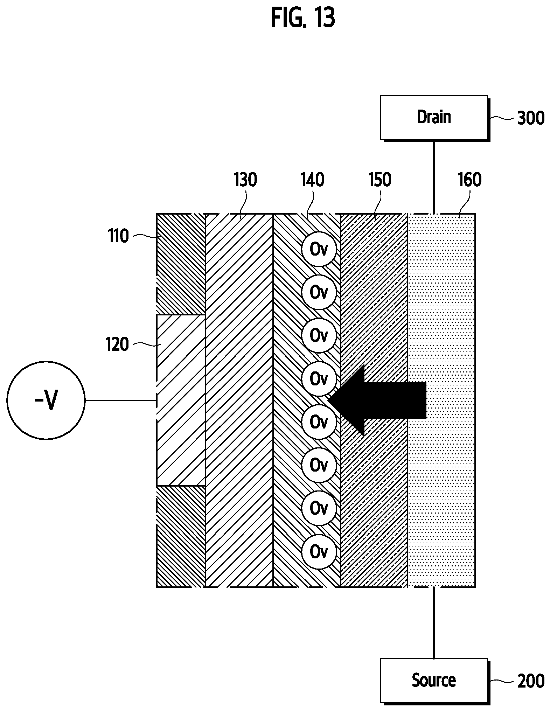

FIGS. 10 to 13 schematically illustrate at least a portion of a memory device 100 of FIG. 1 to describe a method of driving the memory device 100 according to an example embodiment of the present disclosure.

In the method of driving the memory device 100 according to an example embodiment of the present disclosure, when a voltage is applied to the gate electrode 120, the channel layer 160 and the reservoir layer 140 may exchange oxygen vacancies Ov with each other. In one example, when a voltage is applied to the gate electrode 120, oxygen vacancies present in the reservoir layer 140 may be transferred to the channel layer 160, or oxygen vacancies present in the channel layer 160 may be transferred to the reservoir layer 140. Thereby, the electrical conductivity and the threshold voltage of the channel layer 160 may be different from the electrical conductivity and the threshold voltage of the channel layer 160 before the voltage is applied to the gate electrode 120 (e.g., prior to the application of the voltage to the gate electrode 120), respectively.

In one example, when a voltage is applied to the gate electrode 120, the electrolyte layer 150 may smoothly pass oxygen vacancies so that oxygen vacancies are transferred from the channel layer 160 to the reservoir layer 140 or transferred from the reservoir layer 140 to the channel layer 160.

In one example, when a voltage is applied to the gate electrode 120, the gate oxide layer 130 may allow the reservoir layer 140 to smoothly exchange oxygen vacancies with the channel layer 160 and reduce or prevent oxygen vacancies present in the reservoir layer 140 from being transferred to the gate electrode 120.

In one example, the method of driving the memory device 100 may include transferring oxygen vacancies Ov present in the reservoir layer 140 to the channel layer 160 or transferring oxygen vacancies Ov present in the channel layer 160 to the reservoir layer 140 when a voltage is applied to a gate electrode 120. In this case, the electrical conductivity and the threshold voltage of the channel layer 160 may change from the electrical conductivity and the threshold voltage of the channel layer 160before the voltage is applied to the gate electrode 120, respectively. Because the electrical conductivity and the threshold voltage of the channel layer 160 are different (e.g., change), the method of driving the memory device 100 may include performing a write (or program) operation or an erase operation.

In one example, the method of driving the memory device 100 may include transferring, by the reservoir layer 140, oxygen vacancies Ov to the channel layer 160 and performing, by the channel layer 160, the write operation by which the electrical conductivity is increased, when a positive voltage is applied to the gate electrode 120. Here, the method of driving the memory device 100 may include transferring, by the channel layer 160, oxygen vacancies Ov to the reservoir layer 140 and performing the erase operation by which the electrical conductivity of the channel layer 160 is decreased as the oxygen vacancies Ov present in the channel layer 160 are restored to the reservoir layer 140, when a voltage is changed from positive to negative and the changed voltage is applied to the gate electrode 120.

In one example, the method of driving the memory device 100 may include transferring, by the channel layer 160, oxygen vacancies Ov to the reservoir layer 140 and performing, by the channel layer 160, the write operation by which the electrical conductivity is decreased, when a negative voltage is applied to the gate electrode 120. Here, the method of driving the memory device 100 may include transferring, by the reservoir layer 140, oxygen vacancies Ov to the channel layer 160 and performing the erase operation by which the electrical conductivity of the channel layer 160 is increased as the oxygen vacancies Ov present in the reservoir layer 140 are restored to the channel layer 160, when a voltage is changed from negative to positive and the changed voltage is applied to the gate electrode 120.

In one example, the method of driving the memory device 100 may include performing the write or erase operation as a threshold voltage Vₜₕ is changed when a voltage is applied to a gate electrode 120. In one example, the threshold voltage may change due to changes in the electrical conductivity of the channel layer 160. In one example, the method of driving the memory device 100 may include performing the write operation by which the threshold voltage is decreased when a positive voltage is applied to the gate electrode 120. In one example, the method of driving the memory device 100 may include performing the erase operation by which the threshold voltage is increased when a negative voltage is applied to the gate electrode 120.

In one example, the method of driving the memory device 100 may include performing a read operation to check the degree of inclusion of oxygen vacancies Ov (that is, a state of data) through the electrical conductivity of a channel layer 160 by applying a voltage to the gate electrode 120. Here, it may be desirable that the voltage applied to the gate electrode 120 is low enough that movement of oxygen vacancies Ov does not occur. In addition, in one example, the degree of inclusion of oxygen vacancies Ov may be measured through resistance through a current-voltage curve as well as the electrical conductivity of the channel layer 160, through measuring the degree of inclusion of oxygen vacancies Ov, the read operation may be performed. In one example, the method of driving the memory device 100 may include performing a read operation to check the degree of inclusion of oxygen vacancies Ov present in the channel layer 160 through the electrical conductivity of a channel layer 160 by applying a voltage to the gate electrode 120.

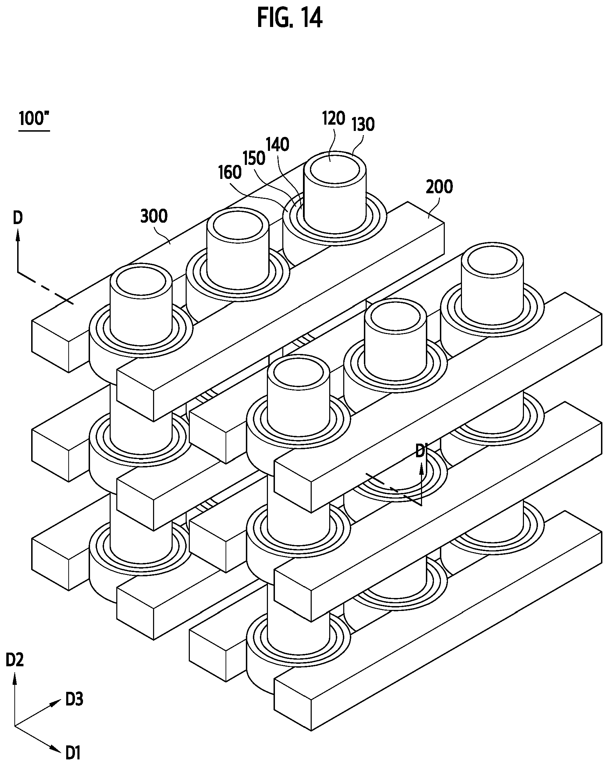

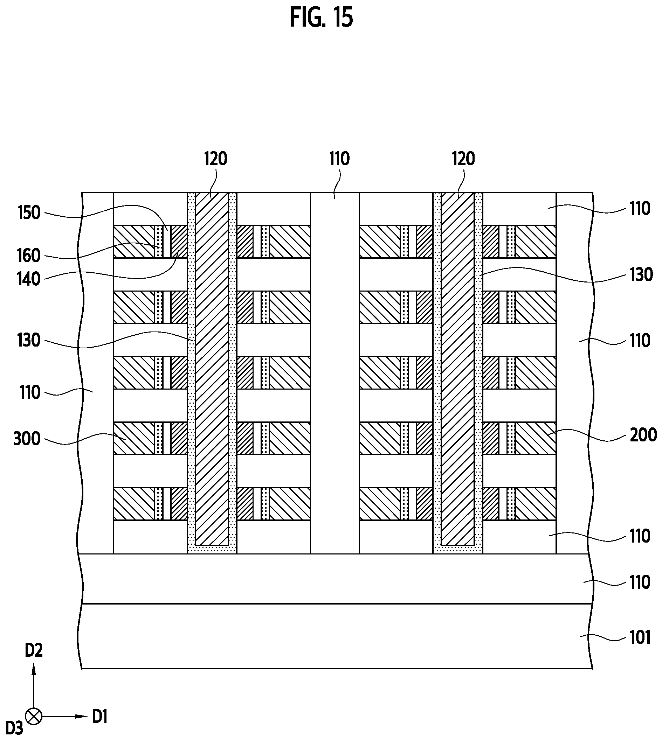

FIG. 14 is a perspective view schematically illustrating at least a portion of a memory device 100", according to an example embodiment of the present disclosure. FIG. 15 is a cross-sectional view taken along line D-D' of FIG. 14. The following description may refer to the preceding contents unless it is contradictory. In one example, the memory device 100 may have a structure similar to a capless DRAM without a capacitor.

In one example, the memory device 100" may include the substrate 101 and the insulating layer 110 in contact with the substrate 101.

In one example, the memory device 100" may include source electrodes 200 spaced apart from each other in the second direction D2, drain electrodes 300 spaced apart from the source electrodes 200 along the first direction D1, and gate electrodes 120 disposed between the source electrodes 200 and the drain electrodes 300. In one example, each of the source electrode 200 and the drain electrode 300 may extend along a third direction D3. In one example, the source electrode 200 may extend parallel to the drain electrode 300 along the third direction D3. In one example, the gate electrode 120 may cross the source electrode 200 and the drain electrode 300. In one example, the gate electrodes 120 may be spaced apart from each other between the source electrode 200 and the drain electrode 300 in the third direction D3 and may extend in the second direction D2.

In one example, the memory device 100"may include the channel layer 160 surrounding a side surface of each of the gate electrodes 120. In one example, the channel layer 160 may surround a side surface of a corresponding gate electrode 120 and may be spaced apart from the gate electrode 120 in the first direction D1. In one example, the channel layer 160 may be disposed between the source electrode 200 and the drain electrode 300. In one example, the source electrode 200 and the drain electrode 300 may each be electrically connected to the channel layer 160.

In one example, the memory device 100"may include the reservoir layer 140 disposed between the gate electrode 120 and the channel layer 160. In one example, the memory device 100 may include the electrolyte layer 150 disposed between the channel layer 160 and the reservoir layer 140. In one example, the memory device 100 may include the gate oxide layer 130 disposed between the gate electrode 120 and the reservoir layer 140.

Hereinafter, the present application are further described with reference to specific examples. The example and comparative examples are intended to illustrate the present application only and not to limit the scope of the appended claims. It will be apparent to those skilled in the art that various changes and modifications to the examples are possible within the scope and technical idea of the present application. Such variations and modifications should be included in the scope of the appended claims.

### Example

A memory device 100 having a structure as shown in FIG. 1 was manufactured, which includes a channel layer 160 including IGZO, an electrolyte layer 150 including hafnium oxide, a reservoir layer 140 including hafnium oxide, and a gate oxide layer 130 including aluminum oxide (AlO), in which the thickness T₁ of the electrolyte layer 150 is about 1 nm, the thickness T₃ of the reservoir layer 140 is about 8 nm, and the thickness of the gate oxide layer 130 is about 10 nm. The electrolyte layer 150, the reservoir layer 140, and the gate oxide layer 130 were formed using the atomic layer deposition (ALD) method.

### Comparative Example 1

A memory device was manufactured in the same manner as in the above-described example, except that the electrolyte layer 150 was omitted.

### Comparative Example 2

A memory device was manufactured in the same manner as in the above-described example, except that the electrolyte layer 150 was deposited with the thickness T₁ of 5 nm.

### Evaluation Example

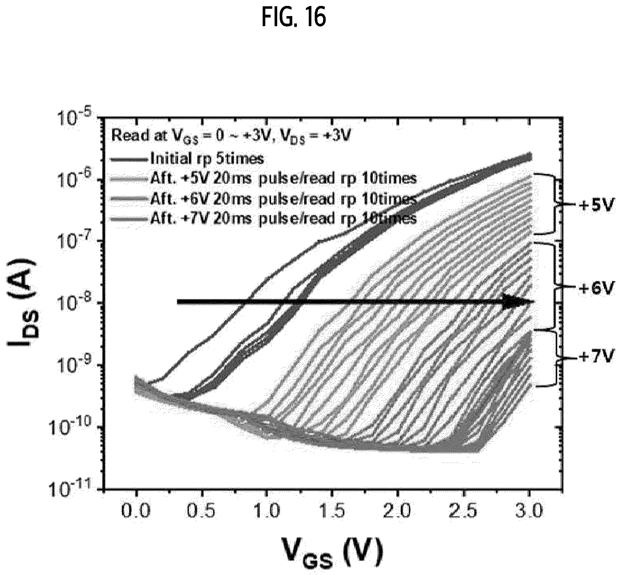

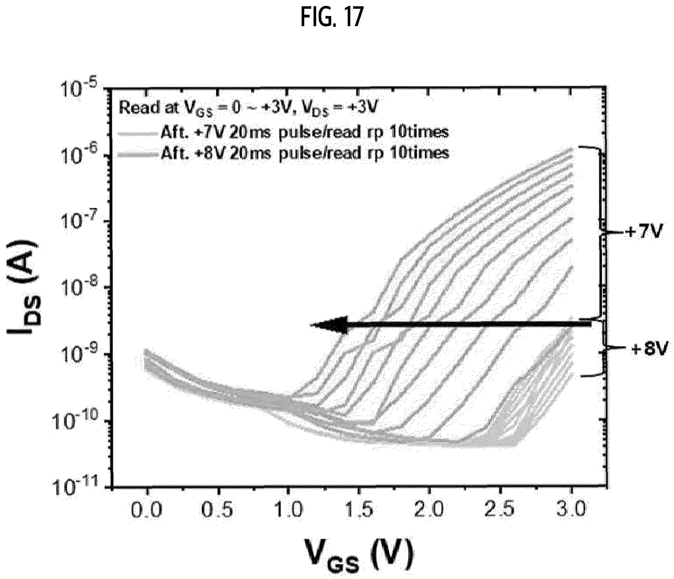

Graphs showing the characteristics of a drain-source current I_{DS} with respect to a gate-source voltage V_{GS} (0 to +3 V) were created by repeatedly applying a voltage to the gate electrode 120 of the memory device 100 of the example ten times with 20 ms per pulse while changing the magnitude of the voltage applied to the gate electrode 120, while maintaining the drain-source voltage V_{DS} at 3 V, and the results thereof are shown in FIGS. 16 and 17.

Referring to FIG. 16, it may be confirmed that the threshold voltage Vₜₕ increases when 5 V, 6 V, and 7 V were applied to the gate electrode 120. The increase may be interpreted to indicate that electrons present in the channel layer moved to the reservoir layer and a charge trap flash (CTF) phenomenon occurred.

Referring to FIG. 17, it may be confirmed that the threshold voltage Vₜₕ decreases when 8 V was applied to the gate electrode 120. The decrease may be interpreted to indicate that the electrochemical (EC) characteristic in which oxygen vacancies present in the reservoir layer are transferred to the channel layer was expressed.

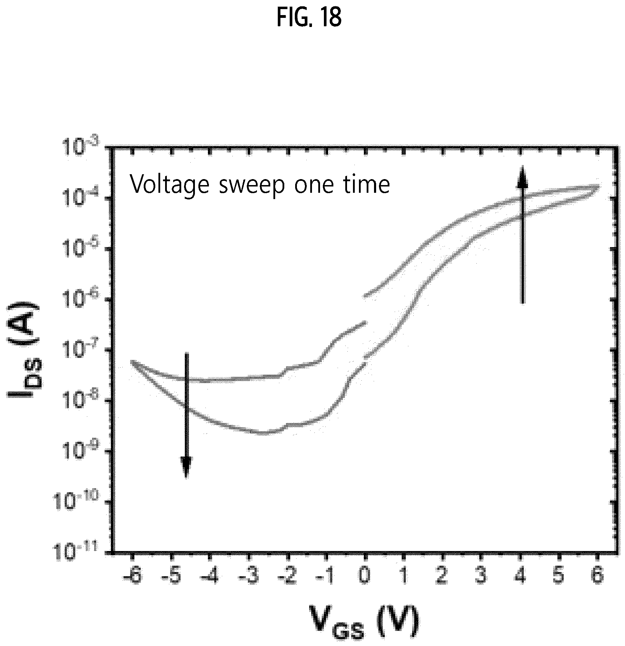

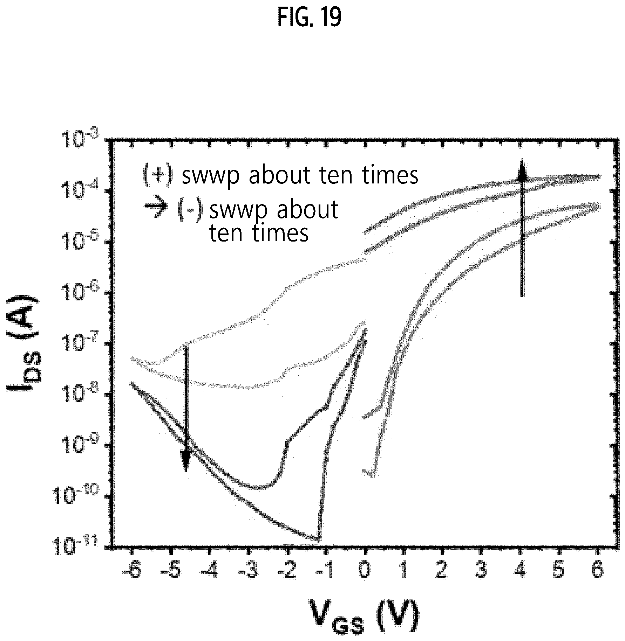

The characteristics of the drain-source current I_{DS} with respect to the gate-source voltage V_{GS} (-6 V to +6 V) of the memory device 100 of the example were measured. Graphs were created after voltage sweeps were performed once and ten times under the above conditions while maintaining the drain-source voltage V_{DS} at 3 V, and the results are shown in FIGS. 18 and 19.

Referring to FIG. 18, it may be confirmed that the implementation of write and erase operations of the memory device 100 is possible.

Referring to FIG. 19, it may be confirmed that the implementation of repetitive write and erase operations of the memory device 100 is possible.

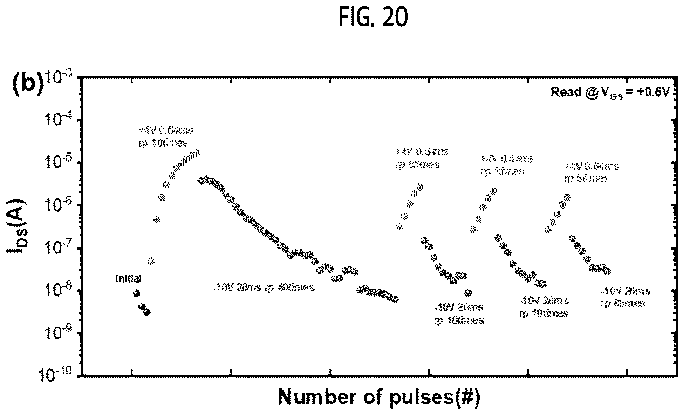

When a positive voltage was applied to the gate electrode 120 of the memory device 100 of the example embodiment under the above conditions with 0.64 ms per pulse for 5 or 10 repetitions and a negative voltage was applied with 20 ms per pulse for 8, 10, or 40 repetitions, a graph obtained by reading the characteristics of current I_{DS} with respect to the number of times a pulse-type voltage is applied by applying Vgs +0.6 V, while maintaining the drain-source voltage V_{DS} at 3 V, was created, and the results thereof are shown in FIG. 20.

Referring to FIG. 20, it may be confirmed that the implementation of repetitive write and erase operations of the memory device 100 is possible.

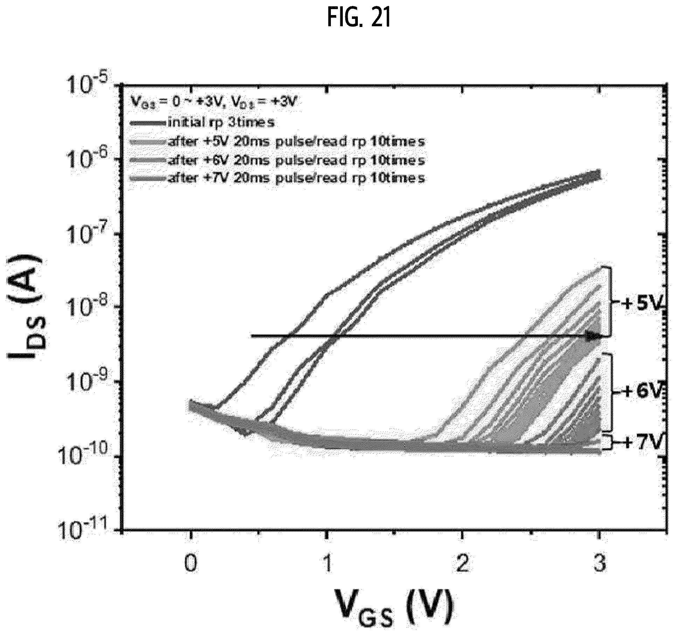

A graph showing the characteristics of the drain-source current I_{DS} with respect to the gate-source voltage V_{GS} (0 to +3 V) was created by repeatedly applying a voltage to a gate electrode of the memory device 100 of Comparative Example 1 ten times with 20 ms per pulse while changing the magnitude of the voltage applied to the gate electrode 120 and maintaining the drain-source voltage V_{DS} at 3 V, and the results thereof are shown in FIG. 21.

Referring to FIG. 21, it may be confirmed that the threshold voltage Vₜₕ increases when 5 V and 6 V were applied to the gate electrode 120. However, when 7 V was applied, the memory device 100 broke down. No decrease in threshold voltage Vₜₕ was observed before the breakdown. When the memory device 100 does not include the electrolyte layer 150, because the channel layer 160 and the reservoir layer 140 only exchange electrons and do not exchange oxygen vacancies, the memory function may not be implemented, and even when the voltage applied to the gate electrode 120 gradually increases, the memory device 100 may break down before the exchange of oxygen vacancies between the channel layer 160 and the reservoir layer 140 occurs.

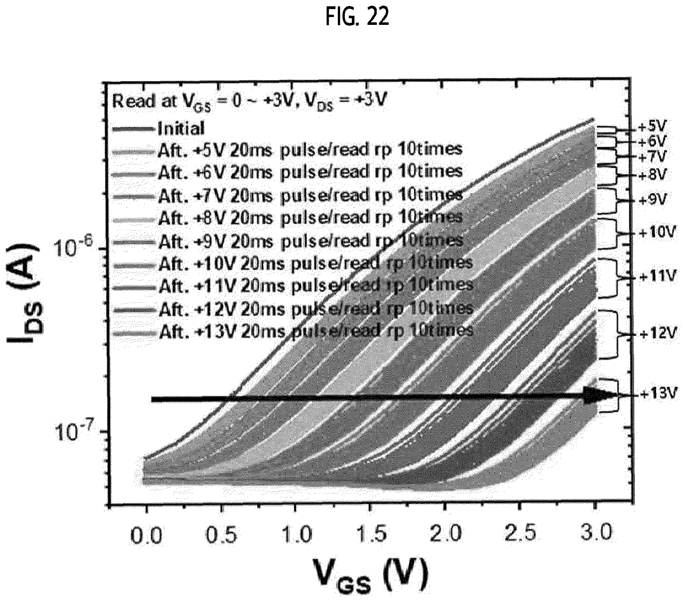

A graph showing the characteristics of the drain-source current I_{DS} with respect to the gate-source voltage V_{GS} (0 to +3 V) was created by repeatedly applying a voltage to a gate electrode of the memory device 100 of Comparative Example 2 ten times with 20 ms per pulse while changing the magnitude of the voltage applied to the gate electrode 120 and maintaining the drain-source voltage V_{DS} at 3 V, and the results thereof are shown in FIG. 22.

Referring to FIG. 22, it may be confirmed that the threshold voltage Vₜₕ increase when 5 V to 13 V were applied to the gate electrode 120. It was confirmed that the memory device 100 of Comparative Example 2 broke down at 14 V, which is a higher voltage compared to Comparative Example 1. However, as in Comparative Example 1, the phenomenon that the threshold voltage Vₜₕ decreases before collapse was not confirmed.

Some example embodiments of the present disclosure may provide memory devices capable of implementing a memory function even when a relatively small voltage is applied to a gate electrode and/or improving integration density, and driving methods of the memory device.

Effects of the present disclosure are not limited to those mentioned above, and other effects not mentioned will be clearly understood by those skilled in the art from the description below.

The present disclosure is not limited to the disclosed example embodiments and may be manufactured in various different forms and those of ordinary skill in the art to which the present disclosure pertains may understand that the additional or alternative example embodiments may be embodied in other specific forms without departing from the technical concept(s) of the present disclosure. Therefore, it is to be appreciated that the example embodiments described above are intended to be illustrative in all respects and not restrictive.

## Claims

1. A memory device comprising:
a substrate;
a channel layer on one surface of the substrate, the channel layer including a semiconductor oxide;
a gate electrode on the channel layer;
a reservoir layer disposed between the channel layer and the gate electrode;
an electrolyte layer between the channel layer and the reservoir layer; and
a gate oxide layer between the gate electrode and the reservoir layer,
wherein the reservoir layer is capable of transferring oxygen vacancies therein to the channel layer or receiving oxygen vacancies transferred from the channel layer, depending on a voltage applied to the gate electrode, and
a thickness of the electrolyte layer is less than 5 nm.

2. The memory device of claim 1, wherein
when a first direction refers to a direction parallel to the one surface of the substrate, the channel layer extends along a second direction intersecting the first direction,
the gate electrode surrounds at least a portion of the channel layer.

3. The memory device of claim 2, further comprising:
a source electrode and a drain electrode electrically connected to the channel layer,
wherein the source electrode and the drain electrode are spaced apart from each other based on the second direction.

4. The memory device of any preceding claim, wherein the channel layer is parallel to the substrate.

5. The memory device of claim 4, further comprising:
a source electrode and a drain electrode electrically connected to the channel layer,
wherein the source electrode and the drain electrode are spaced apart from each other based on a first direction parallel to the one surface of the substrate.

6. The memory device of any preceding claim, wherein the reservoir layer is adapted to transfer the oxygen vacancies to the channel layer when a positive voltage is applied to the gate electrode, and to receive the oxygen vacancies from the channel layer when a negative voltage is applied to the gate electrode.

7. The memory device of any preceding claim, wherein a sum of thicknesses of the reservoir layer, the electrolyte layer, and the gate oxide layer is 30 nanometers (nm) or less.

8. The memory device of any preceding claim, wherein a ratio (T₁/T₂) of a thickness (T₁) of the electrolyte layer and a sum (T₂) of thicknesses of the reservoir layer, the electrolyte layer, and the gate oxide layer is 0.3 or less.

9. The memory device of any preceding claim, wherein the thickness of the electrolyte layer is thinner than a thickness of the reservoir layer.

10. The memory device of any preceding claim, wherein the reservoir layer and the electrolyte layer each independently include an oxide having a metal element-oxygen bond including one or more selected from the group of metal elements consisting of hafnium (Hf), cerium (Ce), tantalum (Ta), gallium (Ga), nickel (Ni), aluminum (Al), zinc (Zn), tungsten (W), vanadium (V), titanium (Ti), niobium (Nb), silicon (Si), germanium (Ge), arsenic (As), tellurium (Te), antimony (Sb), indium (In), zirconium (Zr), and tin (Sn).

11. The memory device of any preceding claim, wherein the channel layer includes one or more selected from the group consisting of indium tungsten oxide (IWO), indium tin gallium oxide (ITGO), indium aluminum zinc oxide (IAZO), indium gallium oxide (IGO), indium tin zinc oxide (ITZO), zinc tin oxide (ZTO), indium zinc oxide (IZO), zinc oxide (ZnO), tungsten oxide (WO), indium gallium silicon oxide (IGSO), indium oxide (InO), tin oxide (SnO), titanium oxide (TiO), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SiInZnO), zinc tin oxide (ZnSnO), aluminum zinc tin oxide (AlZnSnO), gallium zinc tin oxide (GaZnSnO), zirconium zinc tin oxide (ZrZnSnO), and indium gallium silicon oxide (InGaSiO).

12. The memory device of any preceding claim, wherein an oxygen concentration of the electrolyte layer is higher than an oxygen concentration of the reservoir layer.

13. A method of driving a memory device, the memory device including a substrate, a channel layer on one surface of the substrate and including a semiconductor oxide, a gate electrode between the substrate and the channel layer, a reservoir layer between the channel layer and the gate electrode, an electrolyte layer between the channel layer and the reservoir layer and having a thickness of less than 5 nm, and a gate oxide layer between the gate electrode and the reservoir layer, the method comprising, the method comprising:
transferring oxygen vacancies present in the reservoir layer to the channel layer or transferring oxygen vacancies present in the channel layer to the gate electrode when a voltage is applied to the gate electrode such that an electrical conductivity and a threshold voltage (Vₜₕ) of the channel layer change values different from the electrical conductivity and the threshold voltage (Vₜₕ) of the channel layer prior to the application of the voltage to the gate electrode, and
performing a write operation or an erase operation as the electrical conductivity and the threshold voltage of the channel layer changes.

14. The method of claim 13, wherein when the voltage is applied to the gate electrode, the write operation or the erase operation is performed as the threshold voltage (Vₜₕ) changes.

15. The method of claim 13 or 14, wherein
the write operation is performed to transfer the oxygen vacancies present in the reservoir layer to the channel layer by applying a positive voltage to the gate electrode so that the electrical conductivity of the channel layer increases or the threshold voltage (Vₜₕ) decreases compared to the electrical conductivity and the threshold voltage (Vₜₕ) of the channel layer prior to the application of the voltage to the gate electrode, or
the erase operation is performed to transfer the oxygen vacancies present in the channel layer to the reservoir layer by applying a negative voltage to the gate electrode so that the electrical conductivity of the channel layer decreases or the threshold voltage (Vₜₕ) increases compared to the electrical conductivity and the threshold voltage (Vₜₕ) of the channel layer prior to the application of the voltage to the gate electrode.
